# EUROPEAN PATENT APPLICATION

(11) **EP 4 525 561 A1**
(43) Date of publication of application: **19.03.2025**
(21) Application number: 23197828.9
(22) Date of filing: 18.09.2023
(51) Int. Cl.: H05K 1/02, H05K 1/14, H05K 1/16, H05K 3/36

(54) **BRIDGING A SELV BARRIER OF AN ISOLATED DRIVER**

(71) Applicant: Tridonic GmbH & Co. KG, 6851 Dornbirn (AT)
(72) Inventor: Schneider, Miguel Philipp, 6850 Dornbirn (AT); Romano, Fabio, 6850 Dornbirn (AT)
(74) Representative: Rupp, Christian

(57) **Abstract**

A SELV barrier (10) for an isolated driver, especially an isolated LED driver, is provided. Said SELV barrier (10) comprises at least one capacitor (11) for communicating a signal across the SELV barrier (10). In this context, the corresponding electrodes (11a, 11b) of the at least one capacitor (11) are implemented as metallized or metallic surfaces in one printed circuit board (12) or a plurality of superimposed printed circuit boards.

## Description

The present invention relates to bridging a SELV (safety extra-low voltage) barrier of an isolated driver especially in the sense of communicating a signal across the SELV barrier. In particular, the present invention relates to a SELV barrier for an isolated driver, especially an isolated LED driver, an isolated driver, especially an isolated LED driver, comprising such a SELV barrier, and a use of a metallized or metallic surface in an electronic component-carrying printed circuit board of an isolated driver, especially an isolated LED driver.

Generally, in times of an increasing number of applications employing isolated drivers with a SELV barrier, such as LED lighting applications, there is a growing need of a SELV barrier for an isolated driver, especially an isolated LED driver, an isolated driver, especially an isolated LED driver, comprising such a SELV barrier, and a use of a metallized or metallic surface in an electronic component-carrying printed circuit board of an isolated driver, especially an isolated LED driver in order to allow for communicating a signal across such a SELV barrier in a particularly efficient and reliable manner.

Accordingly, there is the object to provide a SELV barrier for an isolated driver, especially an isolated LED driver, an isolated driver, especially an isolated LED driver, comprising such a SELV barrier, and a use of a metallized or metallic surface in an electronic component-carrying printed circuit board of an isolated driver, especially an isolated LED driver, thereby allowing for communicating a signal across such a SELV barrier in a particularly efficient and reliable manner.

This object is solved by the features of the first independent claim for a SELV barrier for an isolated driver, especially an isolated LED driver, the features of the second independent claim for an isolated driver, especially an isolated LED driver, comprising such a SELV barrier, and the features of the third independent claim for a use of a metallized or metallic surface in an electronic component-carrying printed circuit board of an isolated driver, especially an isolated LED driver. The dependent claims contain further developments.

According to a first aspect of the present invention, a SELV barrier for an isolated driver, especially an isolated LED driver, is provided. Said SELV barrier comprises at least one capacitor for communicating a signal across the SELV barrier. In this context, the corresponding electrodes of the at least one capacitor are implemented as metallized or metallic surfaces in one printed circuit board or a plurality of superimposed printed circuit boards.

Advantageously, a signal can be communicated across the SELV barrier in a particularly efficient and reliable manner.

Further advantageously, not only space can be saved but also a longer life of the corresponding circuit can be achieved because fewer components can have a defect.

As a further advantage, especially in the context of the isolated driver or the isolated LED driver, respectively, not only feedback signals can be transferred from a secondary side to a primary side but also gate actuations can be performed on the secondary side starting from the primary side.

According to an implementation form of the first aspect of the present invention, the at least one capacitor comprises or is at least one Y-class capacitor.

Advantageously, for instance, efficiency can further be increased.

According to a further implementation form of the first aspect of the present invention, the corresponding electrodes of the at least one capacitor are isolated against each other preferably with the aid of the respective isolating material, especially the respective resin material, of the printed circuit board or of the plurality of superimposed printed circuit boards.

Advantageously, for example, the isolating material or the resin material can be the respective printed circuit board base material, thereby reducing complexity, which leads to reduced costs.

According to a further implementation form of the first aspect of the present invention, the printed circuit board comprises or is a multi-layer printed circuit board.

Advantageously, for instance, flexibility can be increased, thereby reducing inefficiencies.

According to a further implementation form of the first aspect of the present invention, a first layer of the multi-layer printed circuit board comprises a first one of the corresponding electrodes of the at least one capacitor. Additionally or alternatively, at least a second layer of the multi-layer printed circuit board comprises at least a second one of the corresponding electrodes of the at least one capacitor.

Advantageously, for example, the at least one capacitor can efficiently be implemented.

According to a further implementation form of the first aspect of the present invention, the plurality of superimposed printed circuit boards comprises or is at least or exactly a primary printed circuit board and a secondary printed circuit board.

Advantageously, for instance, the corresponding dielectric strength of the at least one capacitor can efficiently be increased.

According to a further implementation form of the first aspect of the present invention, the primary printed circuit board comprises or is a single-layer primary printed circuit board or a multi-layer primary printed circuit board. Additionally or alternatively, the secondary printed circuit board comprises or is a single-layer secondary printed circuit board or a multi-layer secondary printed circuit board.

Advantageously, for example, complexity can further be reduced, thereby increasing cost-efficiency.

According to a further implementation form of the first aspect of the present invention, the primary printed circuit board comprises a first one of the corresponding electrodes of the at least one capacitor. Additionally or alternatively, the secondary printed circuit board comprises at least a second one of the corresponding electrodes of the at least one capacitor.

Advantageously, for instance, a desired dielectric strength of the at least one capacitor can efficiently be adjusted.

According to a further implementation form of the first aspect of the present invention, the secondary printed circuit board is arranged at a defined distance from the primary printed circuit board, especially from the respective one of the corresponding electrodes of the at least one capacitor or the respective one of the corresponding metallized or metallic surfaces located on the primary printed circuit board.

Advantageously, for example, a desired capacitance of the at least one capacitor can efficiently be adjusted.

According to a further implementation form of the first aspect of the present invention, the secondary printed circuit board is directly arranged on the primary printed circuit board. Alternatively, the secondary printed circuit board is arranged on the primary printed circuit board such that the secondary printed circuit board is separated from the primary printed circuit board by air, especially an air gap, and/or a foil, especially an isolating foil, and/or solder resist.

Advantageously, for instance, the corresponding dielectric strength of the at least one capacitor can be increased in an efficient manner.

According to a further implementation form of the first aspect of the present invention, at least a part or each of the metallized or metallic surfaces comprises or is made of copper.

Advantageously, for example, efficiency can further be increased.

According to a further implementation form of the first aspect of the present invention, a distance between the metallized or metallic surfaces is between 0.3 millimeters and 1.7 millimeters, preferably between 0.5 millimeters and 1.5 millimeters, more preferably between 0.8 millimeters and 1.2 millimeters, most preferably between 0.9 millimeters and 1.1 millimeters.

Advantageously, for instance, reliability can further be increased.

According to a second aspect of the present invention, an isolated driver, especially an isolated LED driver, comprising a SELV barrier according to the first aspect of the present invention or any of its implementation forms, respectively, is provided.

Advantageously, a signal can be communicated across the SELV barrier in a particularly efficient and reliable manner. Further advantageously, not only space can be saved but also a longer life of the corresponding circuit can be achieved because fewer components can have a defect.

As a further advantage, not only feedback signals can be transferred from a secondary side to a primary side but also gate actuations can be performed on the secondary side starting from the primary side.

According to a third aspect of the present invention, a use of a metallized or metallic surface in an electronic component-carrying printed circuit board of an isolated driver, especially an isolated LED driver, as one electrode of at least one capacitor, preferably at least one Y-class capacitor, of the isolated driver, especially the isolated LED driver, is provided.

Advantageously, not only space can be saved but also a longer life of the corresponding circuit can be achieved because fewer components can have a defect.

According to an implementation form of the third aspect of the present invention, the at least one capacitor, preferably the at least one Y-class capacitor, is adapted for communicating a signal across a SELV barrier of the isolated driver, especially the isolated LED driver.

Advantageously, the signal can be communicated across the SELV barrier in a particularly efficient and reliable manner.

Further advantageously, not only feedback signals can be transferred from a secondary side to a primary side but also gate actuations can be performed on the secondary side starting from the primary side.

Exemplary embodiments of the invention are now further explained with respect to the drawings by way of example only, and not for limitation. In the drawings:
- Fig. 1: shows a first exemplary embodiment of a SELV barrier;
- Fig. 2: shows a second exemplary embodiment of a SELV barrier in combination with an isolated driver, especially an isolated LED driver; and
- Fig. 3: shows an exemplary layer structure of a printed circuit board for a SELV barrier.

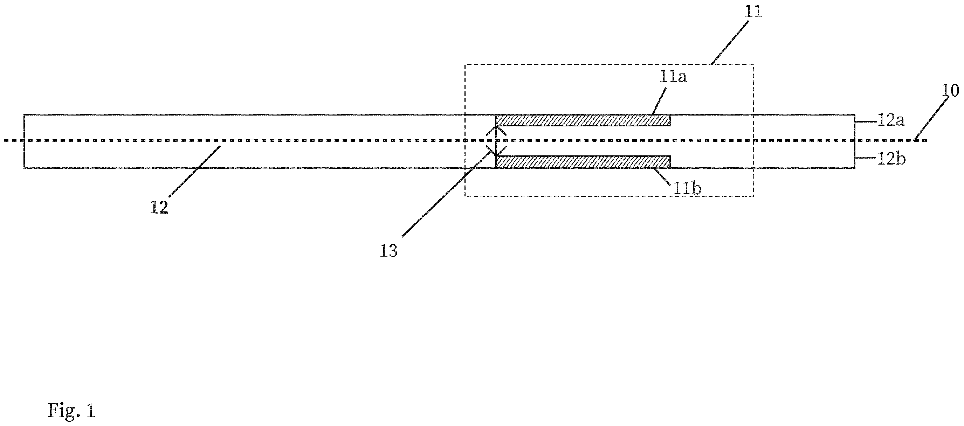

In accordance with Fig. 1, especially illustrating a view of a cross-section of a printed circuit board 12, a first exemplary embodiment of a SELV barrier 10 for an isolated driver, especially an isolated LED driver, comprises at least one capacitor, exemplarily an integrated capacitor 11, for communicating a signal across the SELV barrier 10.

In this context, the corresponding electrodes 11a, 11b of the at least one capacitor or the integrated capacitor 11, respectively, are implemented as metallized or metallic surfaces in one printed circuit board or a plurality of superimposed printed circuit boards, exemplarily in the printed circuit board 12.

As it can further be seen from Fig. 1, the printed circuit board 12 exemplarily comprises two layers, namely a first layer 12a and a second layer 12b.

Further exemplarily, the first layer 12a of the multi-layer, especially the two-layer, printed circuit board 12 comprises the first one 11a of the corresponding electrodes 11a, 11b of the at least one capacitor or the integrated capacitor 11, respectively. Furthermore, the second layer 12b of the multi-layer, especially the two-layer, printed circuit board 12 comprises the second one 11b of the corresponding electrodes 11a, 11b of the at least one capacitor or the integrated capacitor 11, respectively.

It is noted that it might be particularly advantageous if the at least one capacitor or the integrated capacitor 11, respectively, comprises or is at least one Y-class capacitor or a Y-class capacitor, respectively.

It is further noted that the corresponding electrodes 11a, 11b of the at least one capacitor or the integrated capacitor 11 are isolated against each other preferably with the aid of the respective isolating material, especially the respective resin material, of the printed circuit board or of the plurality of superimposed printed circuit boards, exemplarily of the printed circuit board 12

With respect to said isolating material or said resin material, respectively, it is noted that the isolating material or the resin material, respectively, can especially be understood to be the respective printed circuit board base material.

It might be particularly advantageous if the isolating material, especially the resin material, or said printed circuit board base material comprises or is FR4 material.

With respect to the at least one capacitor or the integrated capacitor 11, respectively, it is noted that it might be particularly advantageous if the at least one capacitor or the integrated capacitor 11, respectively, is implemented as a plate capacitor or any kind thereof.

Moreover, with respect to the corresponding electrodes 11a, 11b or the metallized or metallic surfaces, respectively, it is noted that it might be particularly advantageous if at least a part or each of the corresponding electrodes 11a, 11b or the metallized or metallic surfaces, respectively, comprises or is made of copper.

Furthermore, a distance, exemplarily equipped with reference sign 13 in Fig. 1, between the corresponding electrodes 11a, 11b or the metallized or metallic surfaces, respectively, may especially be between 0.3 millimeters and 1.7 millimeters, preferably between 0.5 millimeters and 1.5 millimeters, more preferably between 0.8 millimeters and 1.2 millimeters, most preferably between 0.9 millimeters and 1.1 millimeters.

In this context, especially for the case that the at least one capacitor is a single capacitor such as the integrated capacitor 11 according to Fig. 1, it might be particularly advantageous if said distance 13 is 1 millimeter or between 0.95 millimeters and 1.05 millimeters, preferably between 0.98 millimeters and 1.02 millimeters.

Otherwise, especially for the case that the at least one capacitor is a parallel connection and/or a series connection of multiple capacitors, said distance 13 may preferably be between 0.1 millimeters and 0.7 millimeters or between 0.1 millimeters and 0.3 millimeters.

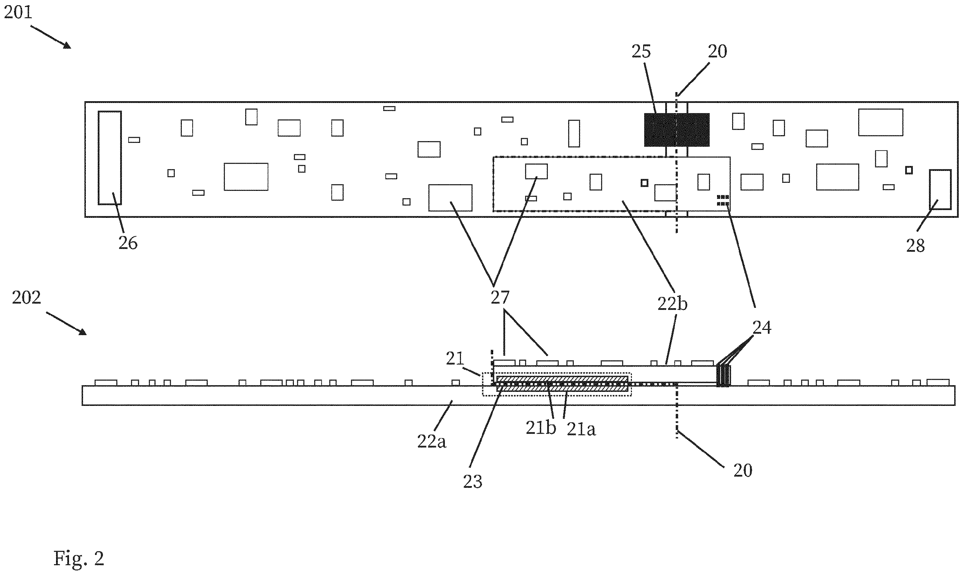

Now, with respect to Fig. 2, especially depicting a corresponding top view 201 and a corresponding view of a cross-section 202, a second exemplary embodiment of a SELV barrier 20 is shown in combination with an isolated driver, especially an isolated LED driver.

As it can be seen from said Fig. 2, the isolated driver or the isolated LED driver, respectively, exemplarily comprises a transformer 25, a mains terminal 26, a multitude of components 27, especially electronic components, and LED connectors 28.

As mentioned in the context of Fig. 1, especially as an alternative to the single printed circuit board 12 of Fig. 1, in this exemplary case according to Fig. 2, a plurality of superimposed printed circuit boards, exemplarily the two superimposed printed circuit boards 22a, 22b, is used.

Said two superimposed printed circuit boards 22a, 22b exemplarily comprise a primary printed circuit board or the main printed circuit board 22a, respectively, and a secondary printed circuit board or the sub-print 22b, respectively.

As it can further be seen from Fig. 2, there are connections 24, especially electrical connections, between the primary printed circuit board or the main printed circuit board 22a, respectively, and the secondary printed circuit board or the sub-print 22b, respectively.

For the sake of completeness, it is noted that further secondary printed circuit boards or at least one further sub-print, respectively, can be used.

By analogy with the SELV barrier 10 according to Fig. 1, the SELV barrier 20 of Fig. 2 for an isolated driver, especially an isolated LED driver, comprises at least one capacitor, exemplarily the capacitor 21, for communicating a signal across the SELV barrier 20.

In this context, the corresponding electrodes 21a, 21b of the at least one capacitor or the capacitor 21, respectively, are implemented as metallized or metallic surfaces in the plurality of superimposed printed circuit boards, exemplarily in the two superimposed printed circuit boards 22a, 22b.

It is noted that all the explanations above regarding the capacitor 11 of Fig. 1 can analogously apply for the capacitor 21 of Fig. 2, and vice versa.

With respect to the primary printed circuit board or the main printed circuit board 22a, respectively, it is noted that the primary printed circuit board or the main printed circuit board 22a, respectively, can comprise or be a single-layer printed circuit board or a multi-layer printed circuit board.

Exemplarily, the primary printed circuit board or the main printed circuit board 22a, respectively, comprises the first one 21a of the corresponding electrodes 21a, 21b of the at least one capacitor or the capacitor 21, respectively.

Especially in the case that the primary printed circuit board or the main printed circuit board 22a, respectively, comprises or is a multi-layer printed circuit board, it might be particularly advantageous if an inner layer of the multi-layer printed circuit board comprises the first one 21a of the corresponding electrodes 21a, 21b especially for a multi-layer printed circuit board with at least three layers or a most distant layer of the multi-layer printed circuit board with respect to the secondary printed circuit board or the sub-print 22b, respectively, comprises the first one 21a of the corresponding electrodes 21a, 21b especially for a multi-layer printed circuit board with two or at least two layers.

With respect the secondary printed circuit board or the sub-print 22b, respectively, it is noted that the secondary printed circuit board or the sub-print 22b, respectively, can comprise or be a single-layer printed circuit board or a multi-layer printed circuit board.

Exemplarily, the secondary printed circuit board or the sub-print 22b, respectively, comprises the second one 21b of the corresponding electrodes 21a, 21b of the at least one capacitor or the capacitor 21, respectively.

Especially in the case that the secondary printed circuit board or the sub-print 22b, respectively, comprises or is a multi-layer printed circuit board, it might be particularly advantageous if an inner layer of the multi-layer printed circuit board comprises the second one 21b of the corresponding electrodes 21a, 21b especially for a multi-layer printed circuit board with at least three layers or a most distant layer of the multi-layer printed circuit board with respect to the primary printed circuit board or the main printed circuit board 22a, respectively, comprises the second one 21b of the corresponding electrodes 21a, 21b especially for a multi-layer printed circuit board with two or at least two layers.

It is further noted that the secondary printed circuit board or the sub-print 22b, respectively, is exemplarily arranged at a defined distance from the primary printed circuit board or the main printed circuit board, respectively, especially from the first one 21a of the corresponding electrodes 21a, 21b of the at least one capacitor, exemplarily the capacitor 21, or the respective one of the corresponding metallized or metallic surfaces located on the primary printed circuit board or the main printed circuit board 22a, respectively.

Moreover, in this exemplary case of Fig. 2, the secondary printed circuit board or the sub-print 22b, respectively, is arranged on the primary printed circuit board or the main printed circuit board 22a, respectively, such that the secondary printed circuit board or the sub-print 22b, respectively, is separated from the primary printed circuit board or the main printed circuit board 22a, respectively, by solder resist and air especially in addition to respective printed circuit board base material, preferably FR4 material.

Especially as an alternative thereto, it is noted that the secondary printed circuit board or the sub-print 22b, respectively, can directly be arranged on the primary printed circuit board or the main printed circuit board 22a, respectively.

It is further noted that all the explanations above regarding the metallized or metallic surfaces of Fig. 1 can analogously apply for the metallized or metallic surfaces of Fig. 2, and vice versa.

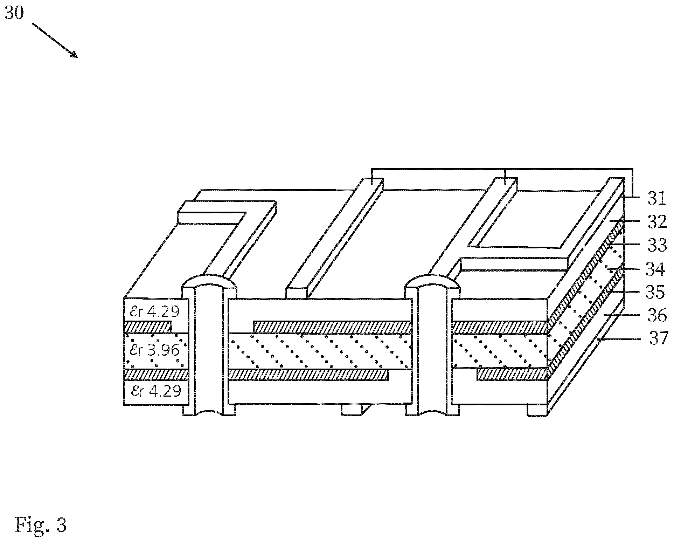

Finally, Fig. 3 illustrates an exemplary layer structure of a multi-layer printed circuit board 30 as mentioned in the context of Fig. 1 or Fig. 2, respectively.

Exemplarily, as it can be seen from Fig. 3, said multi-layer printed circuit board 30 comprises four layers 31, 33, 35, 37. In this context, the first layer 31 and the fourth layer 37 are the outer layers, whereas the second layer 33 and the third layer 35 are the inner layers.

In this context, at least one or each of the four layers 31, 33, 35, 37 comprises a thickness between 30 micrometers and 40 micrometers, especially 35 micrometers.

Preferably, at least one or each of the four layers 31, 33, 35, 37 comprises or is made of copper.

Furthermore, the first layer 31 and the second layer 33 are separated by a first prepreg layer 32 with a thickness between 0.8 millimeters and 0.14 millimeters, preferably a thickness of 0.11 millimeters. The third layer 35 and the fourth layer 37 are separated by a second prepreg layer 36 with a thickness between 0.8 millimeters and 0.14 millimeters, preferably a thickness of 0.11 millimeters. Accordingly, each pair of the inner layers 33, 35 and the corresponding outer layers 31, 37 are separated by a respective prepreg layer 32, 36 with a thickness between 0.8 millimeters and 0.14 millimeters, preferably a thickness of 0.11 millimeters.

Moreover, the second layer 33 and the third layer 35 or the inner layers, respectively, are separated by a core layer 34 with a thickness between 1.07 millimeters and 1.19 millimeters, preferably a thickness of 1.13 millimeters.

With respect to at least one or each of the prepreg layers 32 and 36, it is noted that it might be particularly advantageous if the corresponding relative permittivity of the first prepreg layer 32 or the second prepreg layer 36, respectively, is between 4 and 4.5, preferably between 4.1 and 4.4, more preferably between 4.2 and 4.3, most preferably 4.29.

With respect to the core layer 34, it is noted that it might be particularly advantageous if the corresponding relative permittivity of the core layer 34 is between 3.6 and 4.2, preferably between 3.8 and 4.1, more preferably between 3.9 and 4, most preferably 3.96.

It is further noted that it might be particularly advantageous if the corresponding relative permittivity of the first prepreg layer 32 and/or the corresponding relative permittivity of the second prepreg layer 36 is between 1.03 times and 1.13 times, preferably between 1.05 times and 1.11 times, more preferably between 1.07 times and 1.09 times, most preferably 1.08 times, the corresponding relative permittivity of the core layer 34.

With respect to the printed circuit board 30, it is noted that it might be particularly advantageous if the printed circuit board 30 comprises a thickness between 1.395 millimeters and 1.705 millimeters, preferably between 1.45 millimeters and 1.65 millimeters, more preferably between 1.5 millimeters and 1.6 millimeters, most preferably of 1.55 millimeters.

While various embodiments of the present invention have been described above, it should be understood that they have been presented by way of example only, and not limitation. Numerous changes to the disclosed embodiments can be made in accordance with the disclosure herein without departing from the spirit or scope of the invention. Thus, the breadth and scope of the present invention should not be limited by any of the above described embodiments. Rather, the scope of the invention should be defined in accordance with the following claims and their equivalents.

Although the invention has been illustrated and described with respect to one or more implementations, equivalent alterations and modifications will occur to others skilled in the art upon the reading and understanding of this specification and the annexed drawings. In addition, while a particular feature of the invention may have been disclosed with respect to only one of several implementations, such feature may be combined with one or more other features of the other implementations as may be desired and advantageous for any given or particular application.

## Claims

1. A SELV barrier (10, 20) for an isolated driver, especially an isolated LED driver, comprising:
at least one capacitor (11, 21) for communicating a signal across the SELV barrier (10, 20),
wherein the corresponding electrodes (11a, 11b, 21a, 21b) of the at least one capacitor (11, 21) are implemented as metallized or metallic surfaces in one printed circuit board (12) or a plurality of superimposed printed circuit boards (22a, 22b).

2. The SELV barrier (10, 20) according to claim 1,
wherein the at least one capacitor (11, 21) comprises or is at least one Y-class capacitor.

3. The SELV barrier (10, 20) according to claim 1 or 2,
wherein the corresponding electrodes (11a, 11b, 21a, 21b) of the at least one capacitor (11, 21) are isolated against each other preferably with the aid of the respective isolating material, especially the respective resin material, of the printed circuit board (12) or of the plurality of superimposed printed circuit boards (22a, 22b) .

4. The SELV barrier (10, 20) according to any of the claims 1 to 3,
wherein the printed circuit board (12) comprises or is a multi-layer printed circuit board (12, 30).

5. The SELV (10, 20) barrier according to claim 4,
wherein a first layer (12a) of the multi-layer printed circuit board (12) comprises a first one (11a) of the corresponding electrodes (11a, 11b) of the at least one capacitor (11), and/or
wherein at least a second layer (12b) of the multi-layer printed circuit board (12) comprises at least a second one (11b) of the corresponding electrodes (11a, 11b) of the at least one capacitor (11).

6. The SELV barrier (10, 20) according to any of the claims 1 to 5,
wherein the plurality of superimposed printed circuit boards (22a, 22b) comprises or is at least or exactly a primary printed circuit board (22a) and a secondary printed circuit board (22b).

7. The SELV barrier (10, 20) according to claim 6,
wherein the primary printed circuit board (22a) comprises or is a single-layer primary printed circuit board or a multi-layer primary printed circuit board, and/or
wherein the secondary printed circuit board (22b) comprises or is a single-layer secondary printed circuit board or a multi-layer secondary printed circuit board.

8. The SELV barrier (10, 20) according to claim 6 or 7,
wherein the primary printed circuit board (22a) comprises a first one (21a) of the corresponding electrodes (21a, 21b) of the at least one capacitor (21), and/or
wherein the secondary printed circuit board (22b) comprises at least a second one (21b) of the corresponding electrodes (21a, 21b) of the at least one capacitor (21).

9. The SELV barrier (10, 20) according to any of the claims 6 to 8,
wherein the secondary printed circuit board (22b) is arranged at a defined distance from the primary printed circuit board (22a), especially from the respective one of the corresponding electrodes (21a, 21b) of the at least one capacitor (21) or the respective one of the corresponding metallized or metallic surfaces located on the primary printed circuit board (22a).

10. The SELV barrier (10, 20) according to any of the claims 6 to 9,
wherein the secondary printed circuit board (22b) is directly arranged on the primary printed circuit board (22a), or
wherein the secondary printed circuit board (22b) is arranged on the primary printed circuit board (22a) such that the secondary printed circuit board (22b) is separated from the primary printed circuit board (22a) by air, especially an air gap, and/or a foil, especially an isolating foil, and/or solder resist (23).

11. The SELV barrier (10, 20) according to any of the claims 1 to 10,
wherein at least a part or each of the metallized or metallic surfaces comprises or is made of copper.

12. The SELV barrier (10, 20) according to any of the claims 1 to 11,
wherein a distance (13) between the metallized or metallic surfaces is between 0.3 millimeters and 1.7 millimeters, preferably between 0.5 millimeters and 1.5 millimeters, more preferably between 0.8 millimeters and 1.2 millimeters, most preferably between 0.9 millimeters and 1.1 millimeters.

13. An isolated driver, especially an isolated LED driver, comprising a SELV barrier (10, 20) according to any of the claims 1 to 12.

14. A use of a metallized or metallic surface in an electronic component-carrying printed circuit board (12, 22a, 22b) of an isolated driver, especially an isolated LED driver, as one electrode (11a, 11b, 21a, 21b) of at least one capacitor (11, 21), preferably at least one Y-class capacitor, of the isolated driver, especially the isolated LED driver.

15. The use according to claim 14,
wherein the at least one capacitor (11, 21), preferably the at least one Y-class capacitor, is adapted for communicating a signal across a SELV barrier (10, 20) of the isolated driver, especially the isolated LED driver.
